# EUROPÄISCHE PATENTSCHRIFT

(11) **EP 3 599 636 B1**
(45) Veröffentlichungstag und Bekanntmachung des Hinweises auf die Patenterteilung: **14.09.2022**
(21) Anmeldenummer: 19187264.7
(22) Anmeldetag: 19.07.2019
(51) Int. Cl.: H01L 23/373, C04B 37/00, C04B 37/02

(54) **KERAMISCHER SCHALTUNGSTRÄGER UND ELEKTRONIKEINHEIT**
CERAMIC CIRCUIT CARRIER AND ELECTRONIC UNIT
SUPPORT DE CIRCUIT EN CÉRAMIQUE ET UNITÉ ÉLECTRONIQUE

(30) Priorität: 24.07.2018 DE 102018212272
(43) Veröffentlichungstag der Anmeldung: 29.01.2020
(73) Patentinhaber: Robert Bosch GmbH, 70442 Stuttgart (DE)
(72) Erfinder: Tauber, Peter, 72074 Tuebingen (DE); Graf, Ulrich, 74321 Bietigheim-Bissingen (DE); Sueske, Erik, 72764 Reutlingen (DE); Mueller, Bjoern Jakob, 72074 Tuebingen (DE)

(56) Entgegenhaltungen:
- EP-A2- 1 370 123
- WO-A1-2010/110445
- DE-A1-102009 033 029
- DE-A1-102010 025 313
- JP-A- H 104 156
- JP-A- 2001 274 545
- US-A1- 2015 237 718
- US-A1- 2016 133 533
- US-A1- 2018 005 918

## Beschreibung

Die Erfindung betrifft einen keramischen Schaltungsträger, eine den Schaltungsträger umfassende Elektronikeinheit sowie ein Verfahren zur Ausbildung der Elektronikeinheit gemäß dem Oberbegriff der unabhängigen Ansprüche.

### Stand der Technik

Grundsätzlich sind Elektronikeinheiten mit immer höheren Leistungen gefragt. Dabei nimmt zukünftig eine über Lebensdauer gesicherte Betriebszuverlässigkeit sowie eine immer weiter komprimierte Bauweise einen wichtigen Stellenwert in der Wettbewerbsfähigkeit derartiger Elektronikeinheiten ein. In vielen Fällen kommen hierfür AMB-Substrate (Active Metal Brazing) zum Einsatz, die beispielsweise einen keramischen Kern aus Si3N4 aufweisen und auf deren Oberseite und/oder Unterseite mittels eines Aktiv-Lotverfahrens eine Dickkupfermetallisierung aufgebracht ist. Die Dickkupfermetallisierung ist hierbei aus thermischer und elektrischer Sicht aufgrund der großen Leistungsströme zwingend erforderlich. In gleicher Weise finden hierzu auch sogenannte DBC-Substrate (Direct Bonded Copper) Verwendung. Auch hier liegt ein keramisches Trägersubstrat vor, deren zumindest eine Substratseite mit einer Dickkupfermetallisierung mittels des ansonsten bekannten DBC-Verfahrens fest verbunden wird. Sowohl AMB-Substrate als auch DBC-Substrate weisen durch die Dickkupfermetallisierung eine hohe elektrische Stromtragfähigkeit und Robustheit auf. Anwendungsbedingt durch die hohen thermischen und elektrischen Anforderungen sowie fertigungsbedingt durch die großen Schichtstärken der Dickkupfermetallisierung kann mit gängigen kostengünstigen Fertigungsverfahren nur eine grobe Leiterstruktur innerhalb der Dickkupfermetallisierung als Layout für eine elektronische Schaltung ausgebildet werden. Die Ausbildung der Leiterstruktur erfolgt in der Regel durch einen Ätzprozess. Hierbei müssen für eine fehlerfreie Fertigung und spätere fehlerfreie Anwendung strikte Design-Richtlinien vom Fertiger für das Layout bzw. die Leiterstruktur berücksichtigt werden. So schreiben Design-Richtlinien beispielsweise für ein AMB-Substrat mit einer Dickkupfermetallisierung von 300 µm bis 1000 µm einen Isolationsabstand benachbarter Strukturareal in Abhängigkeit der Dickkupfermetallisierung von mindestens 600 µm bis 1500 µm, eine leitfähige Strukturbreite von 1000 µm bis 1500 µm und ein Pitch-Anschlussmaß zum Anschluss von elektrischen und/oder elektronischen Bauelementen mit der Leiterstruktur von mindestens 1200 µm vor. Dies gilt in ähnliche Weise auch für DBC-Substrate.

Derartige groben Leiterstrukturen eignen sich aber nicht für Logikbauteile, kleine passive Bauelemente oder andere elektrische und/oder elektronischen Bauelemente, die aus betriebsgründen und/oder zur elektrischen Kontaktierung ihrer Anschlusskontakte weit aus feinere Leiterstrukturen auf dem Substrat erfordern. Aus diesem Grund sind bei Elektronikeinheiten mit einem entsprechenden Leistungsbedarf eine hierfür vorgesehene Leistungselektronik und eine mit der Leistungselektronik verbundene Logik- und/oder Ansteuerelektronik auf unterschiedlichen Schaltungsträgern angeordnet. Dadurch müssen verschiedene Nachteile in Kauf genommen werden, wie beispielsweise eine Zunahme von elektrischen Induktivitäten, höhere Herstellkosten für die Elektronikeinheit, eine geringe Integrationsdichte, und anderes.

Aus der Offenlegungsschrift DE102008040290 A1 ist eine Hybridschaltungsstruktur bekannt. Hierbei ist ein Niederstromsubstrat mit einem Leistungssubstrat unter Ausbildung einer Gesamtschaltung elektrisch kontaktiert. Das Leistungssubstrat trägt hierbei die Leistungselektronik der Gesamtschaltung, wogegen die Logikschaltung der Gesamtschaltung auf dem Niederstromschaltung ausgebildet ist.

Aus der Offenlegungsschrift DE 10 2009 033 029 A1 ist ein Schaltungsträgersubstrat bekannt, welches einen isolierenden Kern aufweist, auf welchem eine Metallstrukturierung angeordnet ist. Die Metallstrukturierung weist einen Teilbereich auf, welcher gegenüber einer Basishöhe der Metallstrukturierung hervorsteht. Die Metallstrukturierung wird durch einen Ätzvorgang eingebracht.

Die Offenlegungsschrift JP H1 0004156 A1 zeigt ein AMB-Substrat mit beidseitig zusätzlich angeordneten Leitschichten. Die zusätzlichen Leitschichten sind dabei randseitig zu einem Rand der Leitschichten des AMB-Substrates beabstandet.

Die zusätzlichen Leitschichten weisen darüber hinaus im Randbereich einen Stufenabsatz auf zur Risikominimierung der Bildung von Rissen.

Die Offenlegungsschrift US 2016/0133533 A1 zeigt einen Schaltungsträger mit einer Leiterstruktur, bei welcher isolierte Strukturbereiche mit einem jeweilig randseitigen Stufenprofil ausgebildet sind.

Die Offenlegungsschrift US 2015/0237718 A1 zeigt eine Elektronikvorrichtung, bei welcher auf einer metallischen Leiterstruktur ein Kontaktpad aufgebracht ist. Mit dem dann abstehenden Kontaktpad wird ein Halbleiterbauelement elektrisch kontaktiert.

Die Offenlegungsschrift JP2001274545 A1 zeigt ein Keramiksubstrat mit beidseitig verbundenen Metalloberflächen. Zur Erhöhung einer Temperaturwechselbeständigkeit im Verbindungsbereich zwischen dem Keramiksubstrat und der dann strukturierten Metalloberflächen sind angrenzend zu den metallischen Strukturbereichen fortlaufende flache Gräben im Keramikkern eingebracht. Die Ausbildung der Strukturierung sowie der Gräber erfolgt durch entsprechende Ätzprozesse. Alternativ können diese durch einen Laserabtrag erfolgen.

### Offenbarung der Erfindung

### Vorteile

Der Erfindung liegt die Aufgabe zu Grunde, die Ausbildung einer elektronischen Schaltung einer Elektronikeinheit umfassend einen Leistungsteil und einen Logik- und/oder Ansteuerteil integral auf einem Schaltungsträger zu ermöglichen.

Diese Aufgabe wird durch einen keramischen Schaltungsträger, einen den keramischen Schaltungsträger umfassende Elektronikeinheit sowie ein Verfahren zur Ausbildung der Elektronikeinheit gemäß der unabhängigen Ansprüche gelöst.

Ausgegangen wird von einem keramischen Schaltungsträger mit einem keramischen Trägersubstrat, insbesondere ein DBC (Direct Bonded Copper) - oder ein AMB (Active Metal Brazing) - Schaltungsträger, wobei das Trägersubstrat eine Ober- und eine Unterseite aufweist und auf der Ober- und/oder Unterseite zumindest eine Leiterstruktur umfassend zumindest eine Schicht aus Kupfer oder einer Kupferlegierung angeordnet ist. Die Leiterstruktur weist dabei eine äußerste Abschlussfläche auf und steht in einem senkrechten Schnitt zur Ober- und/oder Unterseite mit einem Höhenmaß von der Oberseite bzw. der Unterseite bis zur äußersten Abschlussfläche ab. Ferner weist die Leiterstruktur zumindest einen ersten Strukturbereich mit einem ersten Höhenmaß und zumindest einen zweiten Strukturbereich mit einem zweiten Höhenmaß auf, wobei das zweite Höhenmaß kleiner ist als das erste Höhenmaß und der erste und der zweite Strukturbereich über das keramische Trägersubstrat elektrisch voneinander isoliert sind. Durch die Unterscheidung der Strukturbereiche eignet sich der Schaltungsträger vorteilhaft zur Ausbildung einer elektrischen und/oder elektronischen Schaltung, die Schaltungsteile aufweist, die an für sich gegenläufige oder wertmäßig unterschiedliche Anforderungen an den Schaltungsträger stellen. So können die unterschiedlichen Strukturbereiche in Hinblick auf beispielswiese eine jeweils erforderliche Stromtragfähigkeit, thermische Beständigkeit und Entwärmungsfähigkeit, eine mechanische Belastbarkeit und anderes bedarfsgerecht unterschiedlich und entsprechend angepasst für ein Elektroniklayout ausgelegt werden. Insbesondere können im ersten Strukturbereich die hohen elektrischen, thermischen und mechanischen Anforderungen zur Anordnung und Ausbildung einer Leistungselektronik erfüllt werden. Gleichzeitig kann hiervon abweichend der zweite Strukturbereich derart ausgebildet sein, dass hier strukturell durch das geringere Höhenmaß die Anordnung und Ausbildung eine Logik- und/oder Ansteuerschaltung ermöglicht ist.

Ferner weist ein Strukturbereich über sein jeweiliges Höhenmaß hinweg Seitenflanken der Leiterstruktur auf, wobei die Seitenflanken im ersten Strukturbereich als Ätzstruktur unter einem schrägen Winkel zu der Ober- und/oder Unterseite ausgebildet sind, und wobei die Seitenflanken im zweiten Strukturbereich als Laserstruktur im Wesentlichen oder annähernd senkrecht zu der Ober- und/oder Unterseite ausgebildet sind. Fertigungsbedingt können geätzte Seitenflanken nie so steil ausgeführt werden wie gelaserte Strukturen. Ebenso fertigungsbedingt laufen geätzte Seitenflanken im geschnittenen Profil über einen Radius aus, wogegen gelaserte Seitenflanken geradlinig bis leicht keglig ausfallen. Strukturell ergeben sich dabei dahingehend Vorteile, dass trotz der fertigungsbedingt unterschiedlich ausgebildeten Profile der Seitenflanken innerhalb der Leiterstruktur Forderungen hinsichtlich einer ausreichenden elektrischen Isolierung aller benachbarten Strukturareale der Leiterstruktur eingehalten werden können. Dies gilt sowohl in einem gröber strukturierten ersten Strukturbereich, in welchem die geätzten Seitenflanken noch innerhalb der größeren Abstandmaße auslaufen können, als auch in einem feiner strukturierten zweiten Strukturbereich, in welchem die gelaserten steileren Seitenflanken überhaupt die notwendigen kleineren Abstandmaße ermöglichen.

Bevorzugt geht der keramische Schaltungsträger aus einem Ausgangssubstrat hervor, wobei bei diesem an wenigstens einer Oberflächenseite wenigstens eine Metallfläche ausgebildet ist, die durch Aufbringen einer flächig durchgehenden, geschlossenen Metallschicht oder Metallfolie mittels des DCB- oder Aktiv-Lot-Verfahrens erzeugt ist. Das Ausgangssubstrat weist demnach vorab keine Leiterstruktur auf. Vielmehr ist diese beim dann vorliegenden keramischen Schaltungsträger aus der ursprünglich durchgehenden, geschlossenen einen Metallschicht oder Metallfolie ausgebildet, insbesondere durch ein - einem Elektroniklayout entsprechend - lokales Entfernen von Material der Metallschicht oder der Metallfolie, beispielsweise einem mechanischen (z.B., Fräsen, Schlitzen), elektrisch physikalischen (z.B. Lasern) und/oder chemischen (z.B. Ätzen) Abtragen. Vorteilhaft weisen damit die unterschiedlichen Strukturbereiche gleichsam eine hohe Anbindung mit dem Trägersubstrat auf. Bevorzugt bildet die der Ober- und/oder Unterseite abgewandte Metallfläche der ursprünglich flächig durchgehenden, geschlossenen Metallschicht oder Metallfolie die äußerste Abschlussfläche des ersten Strukturbereiches mit dann dem ersten Höhenmaß. Auf diese Weise kann der keramische Schaltungsträger zeitlich und von den Kosten mit reduziertem Aufwand hergestellt werden. Bevorzugt kommen dabei als das Ausgangssubstrat ein DBC- oder ein AMB-Substrate zum Einsatz mit einer Schichtdicke der ursprünglich flächig durchgehenden, geschlossenen einen Metallschicht oder Metallfolie von 200 µm bis einschließlich 1500 µm, insbesondere von 300 µm bis einschließlich 1000 µm, vor allem jedoch mit einem in der Branche für einen Serieneinsatz üblichen Standardmaß, beispielsweise mit 300 µm oder 500 µm. Die Leiterstruktur und damit auch die ursprüngliche Metallschicht bzw. Metallfolie des Ausgangssubstrates können dabei auch mehrschichtig vorliegen. Neben der zumindest einen Schicht aus Kupfer oder einer Kupferlegierung sind dann auf dieser weitere metallische Schichten angeordnet, wobei eine letzte angeordnete Schicht die äußerste Abschlussfläche ausbildet. Zumindest eine weitere, mehrere weitere und/oder die letzte Schicht sind bevorzugt als ein Plating aufgebracht, weiter bevorzugt aus Silber, aus Nickel und/oder aus Gold. Andere geeignete Materialien für ein Plating sind ebenso möglich. Das Plating verbessert beispielsweise ein elektrisches Kontaktieren von elektrischen und/oder elektronischen Bauelementen. Sie weisen in der Regel nur dünne Schichtstärken auf, beispielsweise 0,1 - 0,5 µm.

In einer bevorzugten Ausführungsform des keramischen Schaltungsträgers beträgt das zweite Höhenmaß von 20% bis einschließlich 60% des ersten Höhenmaßes, insbesondere von 20% bis einschließlich 40%. Es hat sich vorteilhaft gezeigt, dass gerade in diesem Bereich die Unterscheidungen der beiden Strukturbereiche ausreichend ist, um jeweils den Anforderungen unterschiedlich ausbildbarer Schaltungsteile einer Gesamtschaltung auf dem keramischen Schaltungsträger, insbesondere in Hinblick auf eine Leistungsschaltung einerseits und einer Logik- und/oder Ansteuerschaltung andererseits, besonders gut zu erfüllen. Dies gilt insbesondere bei einem bevorzugten DBC- oder AMB-Schaltungsträger mit einer Schichtdicke der ursprünglich durchgehenden, geschlossenen einen Metallschicht oder Metallfolie von 300 µm bis einschließlich 500 µm als dem ersten Höhenmaß. Das zweite Höhenmaß ist dabei dann bevorzugt von 100 µm bis einschließlich 300 µm, insbesondere von 100 µm bis einschließlich 200 µm. Es gilt ferner, dass das zweite Höhenmaß immer mindestens 50 µm, bevorzugt mindesten 100 µm kleiner ist als das erste Höhenmaß.

Es lassen sich noch weitere vorteilhafte Anpassungen und Unterscheidungen der Strukturbereiche ausführen, um diese dann für jeweils unterschiedlich vorgesehene auszubildende Schaltungsteile zu optimieren.

Hierbei ergibt sich eine günstige Ausführungsform des keramischen Schaltungsträger dadurch, dass ein Strukturbereich zumindest gebildet ist aus zwei oder mehreren direkt benachbarten und über das keramische Trägersubstrat elektrisch voneinander isolierten Strukturarealen, insbesondere in Form von Leiterbahnen und/oder Kontaktanschlusspads, wobei deren äußere Berandung ihrer jeweiligen äußersten Abschlussfläche ein Abstandsmaß zueinander aufweisen und dabei ein minimales Abstandsmaß innerhalb des zweiten Strukturbereiches kleiner ist als ein minimales Abstandsmaß innerhalb des ersten Strukturbereiches. Auf diese Weise kann eine Integrationsdichte der Leiterstruktur durch eine lokal optimierte Anpassung des Abstandsmaß innerhalb eines Strukturbereiches mit geringerem Höhenmaß vergrößert werden. Das minimale Abstandsmaß innerhalb des zweiten Strukturbereiches beträgt dabei bevorzugt von 20 µm bis einschließlich 100 µm, insbesondere von 35 µm bis einschließlich 60 µm. Insbesondere gilt dies für einen DBC- oder AMB-Schaltungsträger mit einer Schichtdicke der ursprünglich flächig durchgehenden, geschlossenen Metallschicht oder Metallfolie bis einschließlich 500 µm.

Die Integrationsdichte lässt sich dabei weiter optimieren, indem sich die Abstandsmaße aller benachbarten Strukturareale an minimale durch vorgegebene Design-Richtlinien noch zulässige Werte orientieren. Insofern erweisen sich Ausführungsformen des keramischen Schaltungsträgers besonders dadurch vorteilhaft, dass die Mehrzahl, bevorzugt alle benachbarten Strukturareale innerhalb des ersten Strukturbereiches ein erstes Abstandsmaß von 700 µm - 1300 µm bei einem ersten Höhenmaß von 400 µm - 600 µm, oder ein erstes Abstandsmaß von 400 µm - 800 µm bei einem ersten Höhenmaß von 200 µm bis unterhalb 400 µm aufweist. Ferner ist bevorzugt, wenn zusätzlich die Mehrzahl, bevorzugt alle benachbarten Kupferareale innerhalb des zweiten Strukturbereiches ein zweites Abstandsmaß von 20 µm - 400 µm, bevorzugt von 20 µm - 250 µm, aufweisen. Nicht betrachtet sind hierbei solche benachbarten Strukturareale innerhalb des zweiten Strukturbereiches, die ein oben genanntes minimales Abstandsmaß aufweisen.

In einer zusätzlichen oder alternativen Weiterbildung des keramischen Schaltungsträgers weist zumindest ein Strukturareal des ersten Strukturbereiches einen Stufenabsatz auf mit zumindest einem ersten und einem zweiten Höhenplateau. Dabei entspricht ein Höhenmaß des ersten Höhenplateaus dem ersten Höhenmaß des ersten Strukturbereiches und ein Höhenmaß des zweiten Höhenplateaus dem zweiten Höhenmaß des zweiten Strukturbereiches. Ferner ist seitlich direkt benachbart zum ersten Höhenplateau zumindest ein Strukturareal des ersten Strukturbereiches beabstandet angeordnet, bevorzugt mit dem ersten Abstandsmaß, und/oder ist seitlich direkt benachbart zum zweiten Höhenplateau zumindest ein Strukturareal des zweiten Strukturbereiches beabstandet angeordnet, bevorzugt mit dem zweiten Abstandsmaß. Vorteilhaft ergibt sich durch den Stufenabsatz eine einfache elektrische Verbindungsbrücke zwischen dem ersten und dem zweiten Strukturbereich, wodurch Schaltungsteile auf unterschiedlichen Höhenebenen elektrisch ohne weitere Verbindungselemente kontaktierbar sind.

Bei einer bevorzugten Ausführungsform des keramischen Schaltungsträgers bildet zumindest eine Gruppe von Strukturarealen des zweiten Strukturbereiches eine Anordnung von Kontaktanschlusspads als Kontaktanschlussschema eines elektrischen und/oder elektronischen Bauelementes aus. Vorteilhaft ist die Anordnung für ein Kontaktanschlussschema ausgelegt, welches ein Fine-Pitch-Anschlussmaß von 50 um bis 600 um aufweist, insbesondere von 50 um bis 300 um. Derartige Fine-Pitch-Anschlussmaße sind in der Regel für eine Vielzahl von elektronischen Bauelementen aus von Anbietern offengelegten Datenblätter entnehmbar. Durch dieses Pitch-Anschlussmaß ist der Mitten-Mitten-Abstand von Kontaktstellen innerhalb des Kontaktanschlussschemas angegeben. Damit lassen sich auch sehr kleine passive Bauelemente, beispielsweise MLCC-Keramikvielschicht-Chipkondensatoren (Multi Layer Ceramic Capacitor), Logikbauteile und andere elektrische und/oder elektronische Bauelemente zur Ausbildung insbesondere einer Logik- und/oder Ansteuerschaltung im Bereich des zweiten Strukturbereiches elektrisch kontaktieren.

Grundsätzlich können in einer einfachen Ausführungsform des keramischen Trägers der erste und der zweite Strukturbereich auf unterschiedlichen Seiten des Trägersubstrates ausgebildet sein. Bei einer bevorzugten Ausführungsform des keramischen Schaltungsträgers sind der erste und der zweite Strukturbereich auf zumindest einer gleichen Seite des Trägersubstrates ausgebildet. Auf diese Weise lassen sich verbesserte elektrische Werte erreichen, beispielsweise verringerte Induktivitäten, insbesondere wenn der keramische Schaltungsträger Teil einer Elektronikeinheit ist, bei welcher im zweiten Strukturbereich eine Logik- und/oder Ansteuerschaltung ausgebildet ist für eine im ersten Strukturbereich ausgebildete Leistungsschaltung.

Die Erfindung führt auch zu einer Elektronikeinheit umfassend einen Schaltungsträger in zumindest einer der zuvor beschriebenen Ausführungsformen eines keramischen Schaltungsträgers, wobei unter Ausbildung einer elektronischen Schaltung elektrische und/oder elektronische Bauelemente mit der Leiterstruktur elektrisch kontaktiert sind. Je nach elektrischen, thermischen und/oder mechanischen Anforderungen können entsprechende Schaltungsteile jeweils mit dem ersten bzw. mit dem zweiten Strukturberiech elektrisch verbunden sein. Besonders bevorzugt ist dabei eine Ausführungsform der Elektronikeinheit, bei welcher die elektronische Schaltung zumindest eine Leistungselektronik und eine Steuerelektronik für die Leistungselektronik umfasst, wobei die zumindest eine Leistungselektronik in dem ersten Strukturbereich und die zumindest eine Steuerelektronik in dem zweiten Strukturbereich angeordnet ist. Trotz Höhenunterschied lassen sich dabei Schaltungsteile innerhalb des ersten und des zweiten Strukturbereiches sehr einfach durch ein Strukturareal mit einem Stufenabsatz elektrisch verbinden. Der Stufenabsatz weist dabei beispielsweise ein erstes Höhenplateau mit dem ersten Höhenmaß und ein zweites Höhenplateau mit dem zweiten Höhenmaß auf. Alternativ lassen sich die unterschiedlichen Schaltungsteile auch über den Höhenunterschied hinweg über einen Metallclip oder einen Bonddraht bzw. Bondbändchen elektrisch verbinden. Bevorzugt umfasst die Leistungselektronik zumindest eine Verstärkerschaltung und/oder die Steuerelektronik zumindest eine Logikschaltung.

Neben einem ersten und einem zweiten Strukturbereich können auch noch weitere Strukturbereiche mit einem anderen Höhenmaß ausgebildet sein.

Die Erfindung führt auch zu einem Verfahren zur Ausbildung einer Elektronikeinheit, insbesondere entsprechend zumindest einer der zuvor beschriebenen Ausführungsformen, mit den nachfolgenden Verfahrensschritten:
a) Bereitstellen eines Ausgangssubstrates des keramischen Schaltungsträgers mit einem keramischen Trägersubstrat, wobei an wenigstens einer Oberflächenseite des keramischen Trägersubstrates wenigstens eine Metallfläche ausgebildet ist, die durch Aufbringen einer Metallschicht oder Metallfolie, insbesondere aus Kupfer oder einer Kupferlegierung, mittels des DCB- oder Aktiv-Lot-Verfahrens erzeugt ist, insbesondere ein DCB (Direct Bonded Copper) - oder ein AMB (Active Metal Brazing) - Schaltungsträger,
b) Ausbilden einer Zwischenstufe einer Leiterstruktur in der Metallschicht oder Metallfolie durch einen Ätzprozess, durch welchen zueinander beabstandete metallische Strukturareale ausgebildet werden, welche über das keramische Trägersubstrat elektrisch voneinander isoliert sind, wobei dabei mittels eines gestuften chemischen Ätzprozesses zumindest ein erstes metallisches Strukturareal mit einem Stufenabsatz ausgebildet wird, welcher zumindest ein erstes Höhenplateau mit einem ersten Höhenmaß und zumindest ein zweites Höhenplateau mit einem zweiten Höhenmaß aufweist, wobei das zweite Höhenmaß kleiner ist als das erste Höhenmaß,
c) Ausbilden einer Endstufe der Leiterstruktur, umfassend zumindest einen ersten Strukturbereich und einen zweiten Strukturbereich, indem über einen Laserabtragungsprozess im Bereich des zweiten Höhenplateaus des Stufenabsatzes metallisches Material der Metallschicht oder der Metallfolie bis zur Oberflächenseite des keramischen Trägersubstrates abgetragen wird, so dass zumindest ein zweites, drittes oder weiteres über das keramische Trägersubstrat elektrisch isoliertes metallisches Strukturareal mit dem zweiten Höhenmaß als der zumindest zweite Strukturbereich vom ursprünglich ersten metallischen Strukturareal getrennt wird, wobei der zumindest erste Strukturbereich durch den verbleibenden Rest des ersten metallischen Strukturareales gebildet wird, insbesondere zusammen mit weiteren durch den Ätzprozess ausgebildeten metallischen Strukturarealen ohne Stufenabsatz, die dann ein dem ersten Höhenmaß entsprechendes Höhenmaß aufweisen,
d) Elektrisches Kontaktieren von Anschlusskontakten von elektrischen und/oder elektronischen Bauelementen mit dem ersten und mit dem zweiten Strukturbereich unter Ausbildung einer elektronischen Schaltung der Elektronikeinheit.

Es sind allgemein gestufte chemische Ätzprozess bekannt. Die Ätzparameter sind insbesondere in Abhängigkeit der Schichtstärke der Metallschicht oder Metallfolie des Ausgangssubstrates festzulegen, um dann unter anderem lokal einen erforderlichen Materialabtrag bis auf das zweite Höhenmaß innerhalb eines festgelegten zweiten Strukturbereiches zu ermöglichen. Ähnliches gilt für den Laserabtragungsprozess. Entsprechend einzustellende Laserparameter orientieren sich dabei maßgeblich auf die nach dem Ätzprozess verbliebenen Schichtdicke mit dem zweiten Höhenmaß. Der Materialabtrag kann hierbei lokal bis mindestens der Oberflächenseite des keramischen Trägersubstrates auf einmal oder durch einen wiederholten Teilabtrag erfolgen. Besonders effizient erfolgt der Materialabtrag im Verfahrensschritt c) durch einen gepulsten Laserprozess, durch welchen abzutragendes Material aufgrund von Laserpulsen erhitzt und verdampft wird. Hierbei kann eine sehr hohe Laserleistung so fokussiert im Bereich der Metallschicht konzentriert werden, dass eine Beschädigung des keramischen Trägersubstrates vermieden wird.

Für eine bevorzugte Ausführungsform des Verfahrens umfasst die elektronische Schaltung zumindest eine Leistungselektronik und eine Steuerelektronik für die Leistungselektronik, wobei die zumindest eine Leistungselektronik dann in dem ersten Strukturbereich ausgebildet wird und die zumindest eine Steuerelektronik in dem zweiten Strukturbereich ausgebildet wird.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine beispielhafte Ausführungsform einer Elektronikeinheit umfassend eine beispielhafte Ausführungsform eines keramischen Schaltungsträgers in einer seitlichen Schnittdarstellung,
- Fig. 2a:: ein Ausgangssubstrat für den keramischen Schaltungsträger aus Fig. 1 in einer seitlichen Schnittdarstellung,
- Fig. 2b:: ein Fertigungszustand des Ausgangssubstrates aus Fig. 2a nach einem Ätzprozess unter Ausbildung einer Zwischenstufe einer Leiterstruktur in einer seitlichen Schnittdarstellung,
- Fig. 2c:: ein fertiggestellter keramischer Schaltungsträger nach einem Laserabtragungsprozess in zuvor geätzen Metallbereichen in einer seitlichen Schnittdarstellung.

### Ausführungsformen der Erfindung

In den Figuren sind funktional gleiche Bauelemente jeweils mit gleichen Bezugszeichen gekennzeichnet.

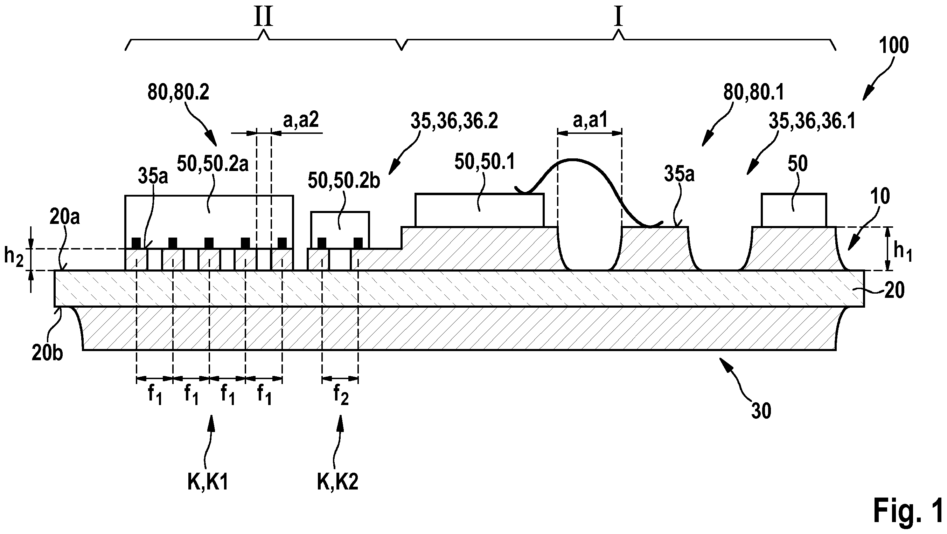

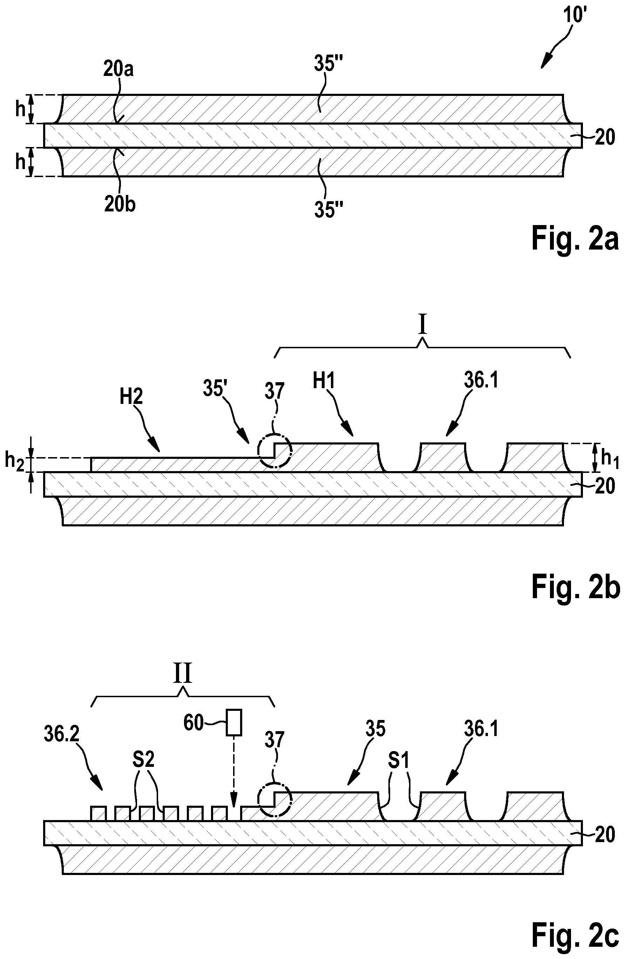

In der Fig. 1 ist eine beispielhafte Ausführungsform einer Elektronikeinheit 100 gezeigt. Diese umfasst eine beispielhafte Ausführungsform eines keramischen Schaltungsträgers 10, dessen Herstellung mit Verweis auf die Fig. 2a - 2c noch beschrieben wird. Der keramische Schaltungsträger 10 weist eine Oberseite 20a und eine Unterseite 20b auf mit jeweils einer Metallisierung umfassend zumindest eine mit der Ober- und/oder Unterseite 20a, 20b verbundene Schicht aus Kupfer oder einer Kupferlegierung. Darüber hinaus können auf der zumindest einen Schicht aus Kupfer oder einer Kupferlegierung weitere Schichten angeordnet sein, insbesondere als Plating, beispielsweise aus Silber, Nickel und/oder Gold. In diesem Ausführungsbeispiel ist auf der Oberseite 20a des keramisches Trägersubstrates 20 in der Metallisierung eine Leiterstruktur 35 ausgebildet, welche mit einer äußersten Abschlussfläche 35a abschließt. Die Leiterstruktur 35 weist dabei eine Vielzahl benachbarter Strukturareal 36 auf, beispielsweise als Leiterbahnen oder Kontaktanschlusspads, die über das keramische Trägersubstrat 20 elektrisch voneinander isoliert sind. Die Berandung in der äußersten Abschlussfläche 35a benachbarter Strukturareale 36 weisen hierbei ein Abstandsmaß a auf. Die Leiterstruktur 35 weist ferner zumindest einen ersten und einen zweiten Strukturbereich I, II auf. Im Strukturbereich II stehen die dort ausgebildeten Strukturareale 36.2 in einem senkrechten Schnitt zur Ober- und/oder Unterseite 20a, 20b mit einem Höhenmaß h2 vom keramischen Trägersubstrat 20 ab. Dabei ist das Höhenmaß h2 kleiner als ein Höhenmaß h1, mit welchem innerhalb des Strukturbereiches I die dort ausgebildeten Strukturareal 36.1 vom keramischen Trägersubstrat 20 abstehen. Insbesondere beträgt das Höhenmaß h2 von 20% - 60% des ersten Höhenmaßes h1, im speziellen von 20% - 40%. Ferner weist der Strukturbereich II ein minimales Abstandsmaß a2 direkt benachbarter Strukturareale 36.2 auf, welches kleiner ist als ein minimales Abstandsmaß a1 direkt benachbarter Strukturareale 36.1 innerhalb des Strukturbereiches I. Ein minimales Abstandsmaß a2 ist bevorzugt von 20 µm bis einschließlich 100 µm, insbesondere von 35 µm bis einschließlich 60 µm. Mit der Leiterstruktur 35 sind über äußerste Abschlussflächen 35a entsprechender Strukturareale 36, 36.1, 36.2 Anschlusskontakte von elektrischen und/oder elektronischen Bauelementen 50 unter Ausbildung einer elektronischen Schaltung 80 elektrisch kontaktiert. Dabei ist innerhalb des Strukturbereiches I eine Teilschaltung der elektronischen Schaltung 80 ausgebildet, die zumindest eine Leistungsschaltung 80.1 umfasst. Die Leistungsschaltung 80.1 weist dabei beispielsweise mindestens einen Leistungshalbleiter 50.1 auf, welcher beispielsweise mit weiteren zu einer Halbbrückenschaltung oder einer B6-Brückeschaltung über entsprechende Strukturareale 36.1 verschaltet ist. Dagegen ist innerhalb des Strukturbereiches II zumindest eine Logik- und/oder Ansteuerschaltung 80.2, insbesondere für die Leistungsschaltung 80.1, als eine weitere Teilschaltung der elektronischen Schaltung 80 ausgebildet. Die Logik- und/oder Ansteuerschaltung 80.2 umfasst beispielsweise ein Logikbauelement 50.2a, insbesondere ein IC (intergrated circuit), ein ASIC, ein Gate-treiber und/oder andere. Es können auch kleine passive Bauelemente, wie beispielsweise MLCC-Keramikvielschicht-Chipkondensatoren (Multi Layer Ceramic Capacitor) 50.2b, enthalten sein. Dabei weisen die Strukturareale 36.2 eine solche Feinstrukturierung auf, dass eine Gruppe dieser Strukturareale 36.2 in einer entsprechenden Anordnung in Form von Kontaktanschlusspads ein Kontaktanschlussschema K, K1, K2 für Bauelemente 50.2a, 50.2b der Logik- und/oder Ansteuerelektronik 80.2 bilden. Insbesondere weist das Kontaktanschlussschema K, K1, K2 ein Fine-Pitch-Anschlussmaß f1, f2 auf, welches den aus Datenblättern für diese Bauelemente 50.2a, 50.2b gefordertem Anschlussmaß entspricht, beispielsweise von 50 um bis 600 um, insbesondere von 50 um bis 300 um.

In den Fig. 2a bis 2c ist die Herstellung des keramischen Schaltungsträgers 10 zu verschiedenen Fertigungsphasen gezeigt. Gemäß Fig. 2a wird hierbei auf ein DBC- oder ein AMB-Schaltungsträger als ein Ausgangssubstrat 10' zurückgegriffen. Das Ausgangssubstrat 10' weist dabei ein keramisches Trägersubstrat 20 auf, wobei auf den Oberflächenseiten 20a, 20b jeweils Metallflächen ausgebildet sind, die durch Aufbringen zumindest einer flächig durchgehenden, geschlossenen Metallschicht oder Metallfolie 35", enthaltend Kupfer oder eine Kupferlegierung, mittels des DBC- oder Aktiv-Lot-Verfahrens erzeugt sind. Die Metallschicht oder Metallfolie 35" weist dabei eine Schichtdicke h auf und ist in diesem Ausführungsbeispiel beidseitig gleich. Die Schichtdicke h beträgt dabei von 300 µm bis einschließlich 1500 µm, insbesondere von 300 µm bis einschließlich 1000 µm, vor allem mit einem in der Branche für einen Serieneinsatz üblichen Standardmaß, beispielsweise mit 300 µm oder 500 µm. Auf mindesten einer Oberflächenseite 20a, 20b des keramischen Trägersubstrates 20 wird gemäß Fig. 2b durch einen Ätzprozess eine erste Zwischenstufe einer Leiterstruktur 35' aus der ursprünglich durchgehenden, geschlossenen Metallschicht oder Metallfolie 35' ausgebildet. In diesem Verfahrensschritt wird bevorzugt bereits der erste Strukturbereich I ausgebildet, welcher eine Grobstruktur aufweist für bereits ausgebildete elektrisch isolierte Strukturareale 36.1. Hierbei wird durch einen gestuften Ätzprozess zeitgleich oder nachträglich zumindest ein Strukturareal 36.1 mit einem Stufenabsatz 37 ausgebildet. Durch den Stufenabsatz 37 weist das betreffende Strukturareal 36.1 zumindest ein erstes und ein zweites Höhenplateau H1, H2 auf. Das erste Höhenplateau H1 entspricht dabei bevorzugt der Schichtdicke h der Metallisierung des Ausgangssubstrates 10 und ist benachbart zu weiteren elektrisch isolierten Strukturarealen 36.1 angeordnet, die das geforderte Höhenmaß h1 aufweisen. Das Höhenplateau H2 dagegen ist auf ein Höhenmaß reduziert, welches dem geforderten Höhenmaß h2 eines noch auszubildenden Strukturbereichs II entspricht.

In einem nachfolgenden Verfahrensschritt wird dann die Endstufe der Leiterstruktur 35 ausgebildet. Hierfür wird mittels eines Lasers 60 ein Laserabtragungsprozess ausgeführt, durch welchen im Bereich des zweiten Höhenplateaus H2 des Stufenabsatzes 37 Material bis zur Oberflächenseite 20a des keramischen Trägersubstrates 20 abgetragen wird. Hierbei werden von dem Höhenplateau H2 ein, zwei oder weitere elektrisch isolierte Strukturareale 36.2 von dem Stufenabsatz 37 abgetrennt, die dann den Strukturbereich II mit einer Feinstruktur bilden. Seitenflanken S2 der Strukturareale 36.2 im zweiten Strukturbereich II sind daher als Laserstruktur ausgebildet, insbesondere im Wesentlichen oder annähernd senkrecht zur Oberseite 20a, wogegen Seitenflanken S1 der Strukturareale 36.1 im ersten Strukturbereich I als Ätzstruktur vorliegen und unter einem schrägen Winkel zu der Ober- und/oder Unterseite 20a, 20b orientiert sind.

Anschließend werden Anschlusskontakten von elektrischen und/oder elektronischen Bauelementen 50, 50.1, 50.2a, 50.2b mit dem ersten und mit dem zweiten Strukturbereich I, II unter Ausbildung der elektronischen Schaltung 80 der Elektronikeinheit 100 gemäß der Fig. 1 elektrisch kontaktiert.

## Patentansprüche

1. Keramischer Schaltungsträger (10) mit einem keramischen Trägersubstrat (20), insbesondere ein DBC (Direct Bonded Copper) - oder ein AMB (Active Metal Brazing) -Schaltungsträger, wobei das Trägersubstrat (20) eine Ober- und eine Unterseite (20a, 20b) aufweist und auf der Ober- und/oder Unterseite (20a, 20b) zumindest eine Leiterstruktur (35) umfassend zumindest eine Schicht aus Kupfer oder einer Kupferlegierung angeordnet ist, und wobei die Leiterstruktur eine äußerste Abschlussfläche (35a) aufweist und in einem senkrechten Schnitt zur Ober- und/oder Unterseite (20a, 20b) mit einem Höhenmaß (h1, h2) von der Oberseite bzw. der Unterseite (20a, 20b) bis zur äußersten Abschlussfläche (35a) absteht, wobei
die Leiterstruktur (35) zumindest einen ersten Strukturbereich (I) mit einem ersten Höhenmaß (h1) und zumindest einen zweiten Strukturbereich (II) mit einem zweiten Höhenmaß (h2) aufweist, wobei das zweite Höhenmaß (h2) kleiner ist als das erste Höhenmaß (h1) und der erste und der zweite Strukturbereich (I, II) über das keramische Trägersubstrat (20) elektrisch voneinander isoliert sind,
**dadurch gekennzeichnet, dass**
ein Strukturbereich (I, II) über sein jeweiliges Höhenmaß hinweg Seitenflanken der Leiterstruktur aufweist, wobei die Seitenflanken (S1) im ersten Strukturbereich (I) als Ätzstruktur unter einem schrägen Winkel zu der Ober- und/oder Unterseite (20a, 20b) ausgebildet sind, und wobei die Seitenflanken (S2) im zweiten Strukturbereich (II) als Laserstruktur im Wesentlichen senkrecht zu der Ober- und/oder Unterseite ausgebildet sind.

2. Keramischer Schaltungsträger (10) nach Anspruch 1,
**dadurch gekennzeichnet, dass**
das zweite Höhenmaß (h2) von 20% bis einschließlich 60% des ersten Höhenmaßes (h1) beträgt, insbesondere von 20% bis einschließlich 40%.

3. Keramischer Schaltungsträger (10) nach einem der Ansprüche 1 oder 2,
**dadurch gekennzeichnet, dass**
ein Strukturbereich (I, II) zumindest gebildet ist aus zwei oder mehreren direkt benachbarten und über das keramische Trägersubstrat (20) elektrisch voneinander isolierten Strukturarealen (36, 36.1, 36.2), insbesondere in Form von Leiterbahnen und/oder Kontaktanschlusspads, wobei deren äußere Berandung ihrer jeweiligen äußersten Abschlussfläche (35a) ein Abstandsmaß (a) zueinander aufweisen und dabei ein minimales Abstandsmaß (a2) innerhalb des zweiten Strukturbereiches (II) kleiner ist als ein minimales Abstandsmaß (a1) innerhalb des ersten Strukturbereiches (I).

4. Keramischer Schaltungsträger (10) nach Anspruch 3,
**dadurch gekennzeichnet, dass**
die Mehrzahl, bevorzugt alle benachbarten Strukturareale (36.1) innerhalb des ersten Strukturbereiches (I) ein erstes Abstandsmaß von 700 µm - 1300 µm bei einem ersten Höhenmaß von 400 - 600 µm oder ein erstes Abstandsmaß von 400 µm) - 800 µm bei einem ersten Höhenmaß von 200 µm bis unterhalb 400 µm und/oder dass die Mehrzahl, bevorzugt alle benachbarten Strukturareale (36.2) innerhalb des zweiten Strukturbereiches (II) ein zweites Abstandsmaß von 20 µm - 400 µm, bevorzugt von 20 µm - 250 µm, aufweisen.

5. Keramischer Schaltungsträger (10) nach einem der Ansprüche 3 oder 4,
**dadurch gekennzeichnet, dass**
zumindest ein Strukturareal (36.1) des ersten Strukturbereiches (I) einen Stufenabsatz (37) aufweist mit zumindest einem ersten und einem zweiten Höhenplateau (H1, H2), wobei ein Höhenmaß des ersten Höhenplateaus (H1) dem ersten Höhenmaß (h1) des ersten Strukturbereiches (I) und ein Höhenmaß des zweiten Höhenplateaus (H2) dem zweiten Höhenmaß (h2) des zweiten Strukturbereiches (II) entspricht, und wobei seitlich direkt benachbart zum ersten Höhenplateau (H1) zumindest ein Strukturareale (36.1) des ersten Strukturbereiches (I) beabstandet angeordnet ist, bevorzugt mit dem ersten Abstandsmaß, und/oder seitlich direkt benachbart zum zweiten Höhenplateau (H2) zumindest ein Strukturareal (36.2) des zweiten Strukturbereiches (II) beabstandet angeordnet ist, bevorzugt mit dem zweiten Abstandsmaß.

6. Keramischer Schaltungsträger (10) nach einem der Ansprüche 3 bis 5,
**dadurch gekennzeichnet, dass**
zumindest eine Gruppe von Strukturarealen (36.2) des zweiten Strukturbereiches (II) eine Anordnung von Kontaktanschlusspads als Kontaktanschlussschema (K, K1, K2) eines elektrischen und/oder elektronischen Bauelementes (50, 50.2a, 50.2b) ausbildet, wobei das Kontaktanschlussschema (K, K1, K2) ein Fine-Pitch-Anschlussmaß (f1, f2) von 50 um bis 600 um aufweist, insbesondere von 50 um bis 300 um.

7. Keramischer Schaltungsträger (10) nach einem der vorhergehenden Ansprüche, **dadurch gekennzeichnet, dass**
der erste und der zweite Strukturbereich (I, II) auf unterschiedlichen Seiten (20a, 20b) des Trägersubstrates (20) ausgebildet sind.

8. Keramischer Schaltungsträger (10) nach einem der Ansprüche 1 bis 6,
**dadurch gekennzeichnet, dass**
der erste und der zweite Strukturbereich (i, II) auf zumindest einer gleichen Seite (20a, 20b) des Trägersubstrates (20) ausgebildet sind.

9. Elektronikeinheit (100) umfassend einen Schaltungsträger (10) nach einem der
Ansprüchen 1 bis 8
wobei unter Ausbildung einer elektronischen Schaltung (80) elektrische und/oder elektronische Bauelemente (50, 50.1, 50.2a, 50.2b) mit der Leiterstruktur (35) elektrisch kontaktiert sind.

10. Elektronikeinheit (100) nach Anspruch 9,
**dadurch gekennzeichnet, dass**
die elektronische Schaltung (80) zumindest eine Leistungselektronik und eine Steuerelektronik für die Leistungselektronik umfasst, wobei die zumindest eine Leistungselektronik in dem ersten Strukturbereich (I) und die zumindest eine Steuerelektronik in dem zweiten Strukturbereich (II) angeordnet ist.

11. Elektronikeinheit (100) nach Anspruch 10,
**dadurch gekennzeichnet, dass**
die Leistungselektronik zumindest eine Verstärkerschaltung (80.1) umfasst und/oder die Steuerelektronik zumindest eine Logikschaltung (80.2) umfasst.

12. Verfahren zur Ausbildung einer Elektronikeinheit (100), insbesondere nach einem der Ansprüche 10 bis 11 mit den nachfolgenden Verfahrensschritten:
a) Bereitstellen eines keramischen Schaltungsträgers (10') mit einem keramischen Trägersubstrat (20), wobei an wenigstens einer Oberflächenseite (20a, 20b) des keramischen Trägersubstrates (20) wenigstens eine Metallfläche ausgebildet ist, die durch Aufbringen einer Metallschicht oder Metallfolie (35"), insbesondere aus Kupfer oder einer Kupferlegierung, mittels des DCB- oder Aktiv-Lot-Verfahrens erzeugt ist, insbesondere ein DCB- oder AMB-Schaltungsträger,
b) Ausbilden einer Zwischenstufe einer Leiterstruktur (35') in der Metallschicht oder Metallfolie (35") durch einen Ätzprozess, durch welchen zueinander beabstandete metallische Strukturareale (36) ausgebildet werden, welche über das keramische Trägersubstrat (20) elektrisch voneinander isoliert sind, wobei dann mittels eines gestuften chemischen Ätzprozesses zumindest ein erstes metallisches Strukturareal (36.1) mit einem Stufenabsatz (37) ausgebildet wird, welcher zumindest ein erstes Höhenplateau (H1) mit einem ersten Höhenmaß (h1) und zumindest ein zweites Höhenplateau (H2) mit einem zweiten Höhenmaß (h2) aufweist, wobei das zweite Höhenmaß (h2) kleiner ist als das erste Höhenmaß (h1),
c) Ausbilden einer Endstufe der Leiterstruktur (35), umfassend zumindest einen ersten Strukturbereich (I) und einen zweiten Strukturbereich (II), indem über einen Laserabtragungsprozess im Bereich des zweiten Höhenplateaus (H2) des Stufenabsatzes (37) metallisches Material der Metallschicht oder der Metallfolie (35") bis zur Oberflächenseite (20a, 20b) des keramischen Trägersubstrates (20) abgetragen wird, so dass zumindest ein zweites, drittes oder weiteres über das keramische Trägersubstrat (20) elektrisch isoliertes metallisches Strukturareal (36.2) mit dem zweiten Höhenmaß (h2) als der zumindest zweite Strukturbereich (II) vom ursprünglich ersten metallischen Strukturareal (36.1) getrennt wird, wobei der zumindest erste Strukturbereich (I) durch den verbleibenden Rest des ersten metallischen Strukturareales (36.1) gebildet wird, insbesondere zusammen mit weiteren durch den Ätzprozess ausgebildeten metallischen Strukturarealen (36.1) ohne Stufenabsatz (37), die dann ein dem ersten Höhenmaß (h1) entsprechendes Höhenmaß aufweisen.
d) Elektrisches Kontaktieren von Anschlusskontakten von elektrischen und/oder elektronischen Bauelementen (50, 50.1, 50.2a, 50.2b) mit dem ersten und mit dem zweiten Strukturbereich (I, II) unter Ausbildung einer elektronischen Schaltung (80) der Elektronikeinheit (100).

13. Verfahren nach Anspruch 12,
**dadurch gekennzeichnet, dass**
die elektronische Schaltung (80) zumindest eine Leistungselektronik (80.1) und eine Steuerelektronik (80.2) für die Leistungselektronik (80.1) umfasst, wobei die zumindest eine Leistungselektronik (80.1) in dem ersten Strukturbereich (I) ausgebildet wird und die zumindest eine Steuerelektronik (80.2) in dem zweiten Strukturbereich (II) ausgebildet wird.

14. Verfahren nach Anspruch 13,
**dadurch gekennzeichnet, dass**
der Materialabtrag im Verfahrensschritt c) durch einen gepulsten Laserprozess erfolgt, durch welchen abzutragendes Material aufgrund von Laserpulsen erhitzt und verdampft wird.

## Claims

1. Ceramic circuit carrier (10) with a ceramic carrier substrate (20), in particular a DBC (Direct Bonded Copper) or AMB (Active Metal Brazing) circuit carrier, wherein the carrier substrate (20) has a top and a bottom side (20a, 20b) and at least one conductor structure (35) comprising at least one layer composed of copper or a copper alloy is arranged on the top and/or the bottom side (20a, 20b), and wherein the conductor structure has an outermost termination surface (35a) and in a perpendicular section in relation to the top and/or the bottom side (20a, 20b) protrudes from the top side and/or the bottom side (20a, 20b), respectively, up to the outermost termination surface (35a) with a height (h1, h2), wherein the conductor structure (35) has at least a first structure region (I) with a first height (h1) and at least a second structure region (II) with a second height (h2), wherein the second height (h2) is smaller than the first height (h1) and the first and the second structure region (I, II) are electrically insulated from one another by means of the ceramic carrier substrate (20),
**characterized in that**
a structure region (I, II) over its respective height has side walls of the conductor structure, wherein the side walls (S1) in the first structure region (I) are formed as an etching structure at an oblique angle in relation to the top and/or the bottom side (20a, 20b), and wherein the side walls (S2) in the second structure region (II) are formed as a laser structure substantially perpendicular in relation to the top and/or the bottom side.

2. Ceramic circuit carrier (10) according to Claim 1, **characterized in that**
the second height (h2) is from 20% up to and including 60% of the first height (h1), in particular from 20% up to and including 40%.

3. Ceramic circuit carrier (10) according to either of Claims 1 and 2,
**characterized in that**
a structure region (I, II) is at least formed from two or more directly adjacent structure areas (36, 36.1, 36.2) which are electrically insulated from one another by means of the ceramic carrier substrate (20), in particular in the form of conductor tracks and/or contact connection pads, wherein their outer boundaries of their respective outermost termination surface (35a) have a spacing (a) from each other and in this case a minimum spacing (a2) within the second structure region (II) is smaller than a minimum spacing (a1) within the first structure region (I).

4. Ceramic circuit carrier (10) according to Claim 3, **characterized in that**
the majority of, preferably all of, the adjacent structure areas (36.1) within the first structure region (I) have a first spacing of 700 µm - 1300 µm at a first height of 400 - 600 µm or a first spacing of 400 µm - 800 µm at a first height of 200 µm to below 400 µm and/or in that the majority of, preferably all of, the adjacent structure areas (36.2) within the second structure region (II) have a second spacing of 20 µm - 400 µm, preferably of 20 µm - 250 µm.

5. Ceramic circuit carrier (10) according to either of Claims 3 and 4,
**characterized in that**
at least one structure area (36.1) of the first structure region (I) has a step (37) with at least a first and a second height plateau (H1, H2), wherein a height of the first height plateau (H1) corresponds to the first height (h1) of the first structure region (I) and a height of the second height plateau (H2) corresponds to the second height (h2) of the second structure region (II), and wherein, laterally directly adjacent to the first height plateau (H1), at least one structure area (36.1) of the first structure region (I) is arranged in spaced-apart fashion, preferably with the first spacing, and/or, laterally directly adjacent to the second height plateau (H2), at least one structure area (36.2) of the second structure region (II) is arranged in spaced-apart fashion, preferably with the second spacing.

6. Ceramic circuit carrier (10) according to one of Claims 3 to 5,
**characterized in that**
at least one group of structure areas (36.2) of the second structure region (II) forms an arrangement of contact connection pads as contact connection scheme (K, K1, K2) of an electrical and/or electronic component (50, 50.2a, 50.2b), wherein the contact connection scheme (K, K1, K2) has a fine-pitch connection dimension (f1, f2) of 50 µm to 600 µm, in particular of 50 µm to 300 µm.

7. Ceramic circuit carrier (10) according to one of the preceding claims,
**characterized in that**
the first and the second structure region (I, II) are formed on different sides (20a, 20b) of the carrier substrate (20).

8. Ceramic circuit carrier (10) according to one of Claims 1 to 6,
**characterized in that**
the first and the second structure region (I, II) are formed on at least one same side (20a, 20b) of the carrier substrate (20).

9. Electronics unit (100) comprising a circuit carrier (10) according to one of Claims 1 to 8, wherein electrical and/or electronic components (50, 50.1, 50.2a, 50.2b) are electrically contact-contacted to the conductor structure (35) so as to form an electronic circuit (80).

10. Electronics unit (100) according to Claim 9, **characterized in that**
the electronic circuit (80) comprises at least one power electronics system and one control electronics system for the power electronics system, wherein the at least one power electronics system is arranged in the first structure region (I) and the at least one control electronics system is arranged in the second structure region (II).

11. Electronics unit (100) according to Claim 10, **characterized in that**
the power electronics system comprises at least one amplifier circuit (80.1) and/or the control electronics system comprises at least one logic circuit (80.2).

12. Method for forming an electronics unit (100), in particular according to either of Claims 10 and 11, comprising the following method steps:
a) providing a ceramic circuit carrier (10') with a ceramic carrier substrate (20), wherein at least one metallic surface is formed on at least one surface side (20a, 20b) of the ceramic carrier substrate (20), which surface is produced by applying a metal layer or metal foil (35"), in particular composed of copper or a copper alloy, by means of the DCB or active soldering method, in particular a DCB or AMB circuit carrier,
b) forming an intermediate stage of a conductor structure (35') in the metal layer or metal foil (35") by an etching process by way of which metallic structure areas (36) which are spaced apart from one another and are electrically insulated from one another by means of the ceramic carrier substrate (20) are formed, wherein then, by means of a stepped chemical etching process, at least a first metallic structure area (36.1) is formed with a step (37) which has at least a first height plateau (H1) with a first height (h1) and at least a second height plateau (H2) with a second height (h2), wherein the second height (h2) is smaller than the first height (h1),
c) forming an end stage of the conductor structure (35), comprising at least a first structure region (I) and a second structure region (II), by way of metallic material of the metal layer or of the metal foil (35") being removed down to the surface side (20a, 20b) of the ceramic carrier substrate (20) by means of a laser removal process in the region of the second height plateau (H2) of the step (37), so that at least a second, third or further metallic structure area (36.2) which is electrically insulated by means of the ceramic carrier substrate (20) and has the second height (h2) is, as the at least second structure region (II), separated from the originally first metallic structure area (36.1), wherein the at least first structure region (I) is formed by the remaining part of the first metallic structure area (36.1), in particular together with further metallic structure areas (36.1) formed by the etching process without step (37) which then have a height corresponding to the first height (h1),
d) electrically contact-connecting connection contacts of electrical and/or electronic components (50, 50.1, 50.2a, 50.2b) to the first and to the second structure region (I, II) so as to form an electronic circuit (80) of the electronics unit (100).

13. Method according to Claim 12,
**characterized in that**
the electronic circuit (80) comprises at least one power electronics system (80.1) and one control electronics system (80.2) for the power electronics system (80.1), wherein the at least one power electronics system (80.1) is formed in the first structure region (I) and the at least one control electronics system (80.2) is formed in the second structure region (II).

14. Method according to Claim 13,
**characterized in that**
the material removal in method step c) is performed by a pulsed laser process by way of which material that is to be removed is heated and evaporated by laser pulses.

## Revendications

1. Support de circuit en céramique (10) comprenant un substrat porteur en céramique (20), notamment un support de circuit DBC (Direct Bonded Copper - Cuivre à liaison directe) ou AMB (Active Métal Brazing - Brasage métallique actif), le substrat porteur (20) possédant un côté supérieur et un côté inférieur (20a, 20b) et au moins une structure conductrice (35) comportant au moins une couche de cuivre ou d'un alliage de cuivre étant disposée sur le côté supérieur et/ou le côté inférieur (20a, 20b), et la structure conductrice possédant une surface de terminaison la plus à l'extérieur (35a) et, en coupe perpendiculaire par rapport au côté supérieur et/ou au côté inférieur (20a, 20b), dépassant du côté supérieur ou du côté inférieur (20a, 20b) avec une cote de hauteur (h1, h2) jusqu'à la surface de terminaison la plus à l'extérieur (35a),
la structure conductrice (35) possédant au moins une première zone de structure (I) ayant une première cote de hauteur (h1) et au moins une deuxième zone de structure (II) ayant une deuxième cote de hauteur (h2), la deuxième cote de hauteur (h2) étant inférieure à la première cote de hauteur (h1) et la première et la deuxième zone de structure (I, II) étant isolées électriquement l'une de l'autre par le biais du substrat porteur (20) en céramique,
**caractérisé en ce que**
une zone de structure (I, II) possède des flancs latéraux de la structure conductrice au-delà de sa cote de hauteur respective, les flancs latéraux (S1) dans la première zone de structure (I) étant réalisés sous la forme d'une structure gravée sous un angle oblique par rapport au côté supérieur et/ou au côté inférieur (20a, 20b), et les flancs latéraux (S2) dans la deuxième zone de structure (II) étant réalisés sous la forme d'une structure laser sensiblement perpendiculaire au côté supérieur et/ou au côté inférieur.

2. Support de circuit en céramique (10) selon la revendication 1, **caractérisé en ce que** la deuxième cote de hauteur (h2) est égale à 20 % à 60 % inclus de la première cote de hauteur (h1), notamment à 20 % à 40% inclus.

3. Support de circuit en céramique (10) selon l'une des revendications 1 et 2, **caractérisé en ce qu'**une zone de structure (I, II) est formée au moins par deux ou plusieurs aires de structure (36, 36.1, 36.2) directement voisines et isolées électriquement les unes des autres par le biais du substrat porteur (20) en céramique, notamment sous la forme de pistes conductrices et/ou de pastille de raccordement de contact, la bordure extérieure de leur surface de terminaison la plus à l'extérieur (35a) présentant une cote d'écart (a) entre elles et une cote d'écart minimale (a2) au sein de la deuxième zone de structure (II) étant ici inférieure à une cote d'écart minimale (a1) au sein de la première zone de structure (I).

4. Support de circuit en céramique (10) selon la revendication 3, **caractérisé en ce que** la pluralité de, de préférence toutes les aires de structure (36.1) voisines au sein de la première zone de structure (I) présentent une première cote d'écart de 700 µm à 1300 µm avec une première cote de hauteur de 400 à 600 µm ou une première cote d'écart de 400 µm à 800 µm avec une première cote de hauteur de 200 µm à moins de 400 µm et/ou **en ce que** la pluralité de, de préférence toutes les aires de structure (36.2) voisines au sein de la deuxième zone de structure (II) présentent une deuxième cote d'écart de 20 µm à 400 µm, de préférence de 20 µm à 250 µm.

5. Support de circuit en céramique (10) selon l'une des revendications 3 et 4, **caractérisé en ce qu'**au moins une aire de structure (36.1) de la première zone de structure (I) présente un talon étagé (37) ayant au moins un premier et un deuxième plateau de hauteur (H1, H2), une cote de hauteur du premier plateau de hauteur (H1) correspondant à la première cote de hauteur (h1) de la première zone de structure (I) et une cote de hauteur du deuxième plateau de hauteur (H2) correspondant à la deuxième cote de hauteur (h2) de la deuxième zone de structure (II), au moins une aire de structure (36.1) de la première zone de structure (I) étant disposée de manière espacée latéralement directement au voisinage du premier plateau de hauteur (H1), de préférence avec la première cote d'écart, et/ou au moins une aire de structure (36.2) de la deuxième zone de structure (II) étant disposée de manière espacée latéralement directement au voisinage du deuxième plateau de hauteur (H2), de préférence avec la deuxième cote d'écart.

6. Support de circuit en céramique (10) selon l'une des revendications 3 à 5, **caractérisé en ce qu'**au moins un groupe d'aires de structure (36.2) de la deuxième zone de structure (II) forme un arrangement de pastilles de raccordement de contact en tant que schéma de raccordement de contact (K, K1, K2) d'un composant électrique et/ou électronique (50, 50.2a, 50.2b), le schéma de raccordement de contact (K, K1, K2) possédant une cote de raccordement à pas fin (f1, f2) de 50 µm à 600 µm, notamment de 50 µm à 300 µm.

7. Support de circuit en céramique (10) selon l'une des revendications précédentes, **caractérisé en ce que** la première et la deuxième zone de structure (I, II) sont formées sur des côtés (20a, 20b) différents du substrat porteur (20).

8. Support de circuit en céramique (10) selon l'une des revendications 1 à 6, **caractérisé en ce que** la première et la deuxième zone de structure (I, II) sont formées sur au moins un même côté (20a, 20b) du substrat porteur (20).

9. Unité électronique (100) comprenant un support de circuit (10) selon l'une des revendications 1 à 8, des composants électriques et/ou électroniques (50, 50.1, 50.2a, 50.2b) étant mis en contact électrique avec la structure conductrice (35) en formant un circuit électronique (80).

10. Unité électronique (100) selon la revendication 9, **caractérisée en ce que** le circuit électronique (80) comporte au moins une électronique de puissance et une électronique de commande pour l'électronique de puissance, l'au moins une électronique de puissance étant disposée dans la première zone de structure (I) et l'au moins une électronique de commande étant disposée dans la deuxième zone de structure (II).

11. Unité électronique (100) selon la revendication 10, **caractérisée en ce que** l'électronique de puissance comporte au moins un circuit amplificateur (80.1) et/ou l'électronique de commande comporte au moins un circuit logique (80.2).

12. Procédé pour former une unité électronique (100), notamment selon l'une des revendications 10 et 11, comprenant les étapes de procédé suivantes :
a) fourniture d'un support de circuit en céramique (10') comprenant un substrat porteur en céramique (20), au moins une surface métallique étant formée sur au moins un côté de surface (20a, 20b) du substrat porteur en céramique (20), laquelle est produite par dépose d'une couche métallique ou d'un film métallique (35"), notamment en cuivre ou un alliage de cuivre, au moyen d'un procédé DCB ou de brasage actif, notamment un support de circuit DCB ou AMB,
b) formation d'un étage intermédiaire d'une structure conductrice (35') dans la couche métallique ou le film métallique (35") par un processus de gravure, par lequel sont formées des aires de structure (36) métalliques espacées les unes des autres, lesquelles sont isolées électriquement les unes des autres par le substrat porteur en céramique (20), au moins une première aire de structure (36.1) métallique pourvue d'un talon étagé (37) étant ensuite formée au moyen d'un processus de gravure chimique étagé, lequel talon étagé présente au moins un premier plateau de hauteur (H1) ayant une première cote de hauteur (h1) et au moins un deuxième plateau de hauteur (H2) ayant une deuxième cote de hauteur (h2), la deuxième cote de hauteur (h2) étant inférieure à la première cote de hauteur (h1),
c) formation d'un étage final de la structure conductrice (35), comprenant au moins une première zone de structure (I) et une deuxième zone de structure (II), en enlevant du matériau métallique de la couche métallique ou du film métallique (35") jusqu'au côté de surface (20a, 20b) du substrat porteur (20) en céramique par le biais d'un processus d'enlèvement au laser dans la zone du deuxième plateau de hauteur (H2) du talon étagé (37), de sorte qu'au moins une deuxième, une troisième ou une autre aire de structure (36.2) métallique électriquement isolée par le biais du substrat porteur (20) en céramique ayant la deuxième cote de hauteur (h2) soit séparée en tant qu'au moins la deuxième zone de structure (II) de la première aire de structure (36.1) métallique originelle, au moins la première zone de structure (I) étant formée par le reste de la première aire de structure (36.1) métallique, notamment conjointement avec des aires de structure (36.1) métalliques supplémentaires formées par le processus de gravure sans talon étagé (37), lesquelles présentent alors une cote de hauteur correspondant à la première cote de hauteur (h1),
d) mise en contact électrique de contacts de raccordement de composants électriques et/ou électroniques (50, 50.1, 50.2a, 50.2b) avec la première et avec la deuxième zone de structure (I, II) en formant un circuit électronique (80) de l'unité électronique (100) .

13. Procédé selon la revendication 12, **caractérisé en ce que** le circuit électronique (80) comporte au moins une électronique de puissance (80.1) et une électronique de commande (80.2) pour l'électronique de puissance (80.1), l'au moins une électronique de puissance (80.1) étant formée dans la première zone de structure (I) et l'au moins une électronique de commande (80.2) étant formée dans la deuxième zone de structure (II).

14. Procédé selon la revendication 13, **caractérisé en ce que** l'enlèvement de matière à l'étape c) du procédé est effectué par un processus au laser pulsé, par lequel la matière à enlever est chauffée et vaporisée en raison des impulsions laser.
